# FASCICULE DE BREVET EUROPEEN

(11) **EP 1 673 306 B1**
(45) Date de publication et mention de la délivrance du brevet: **16.04.2008**
(21) Numéro de dépôt: 04817217.5
(22) Date de dépôt: 12.10.2004
(51) Int. Cl.: C01B 31/02

(54) **Procédé de synthese de structures filamentaires nanomètrique et composants pour l'électronique comprenant de telles structures**
Verfahren zur Synthese von Filamentstrukturen im Nanometerbereich und elektronische Bauteile mit derartigen Strukturen
Method for the synthesis of filament structures on a nanometre scale and electronic components comprising such structures

(30) Priorité: 13.10.2003 FR 0311959
(43) Date de publication de la demande: 28.06.2006
(73) Titulaire: CENTRE NATIONAL DE LA RECHERCHE SCIENTIFIQUE (CNRS), 75794 Paris Cedex 16 (FR); Ecole Polytechnique Dgar, 91128 Palaiseau Cedex (FR)
(72) Inventeur: PRIBAT, Didier, F-92310 Sevres (FR); WEGROWE, Jean-Eric, F-75014 Paris (FR); WADE, Travis, F-75014 Paris (FR)
(74) Mandataire: Texier, Christian
(86) Numéro de dépôt international: PCT/FR2004/002584
(87) Numéro de publication internationale: WO 2005/037710

(56) Documents cités:
- EP-A- 1 331 202
- WO-A-00/73204
- WO-A-03/069019
- US-A1- 2002 136 681
- US-B1- 6 346 189
- LI J ET AL: "HIGHLY-ORDERED CARBON NANOTUBE ARRAYS FOR ELECTRONICS APPLICATIONS" APPLIED PHYSICS LETTERS, AMERICAN INSTITUTE OF PHYSICS. NEW YORK, US, vol. 75, no. 3, 19 juillet 1999 (1999-07-19), pages 367-369, XP000850812 ISSN: 0003-6951
- LEW K-K ET AL: "Growth characteristics of silicon nanowires synthesized by vapor-liquid-solid growth in nanoporous alumina templates" JOURNAL OF CRYSTAL GROWTH, NORTH-HOLLAND PUBLISHING CO. AMSTERDAM, NL, vol. 254, no. 1-2, juin 2003 (2003-06), pages 14-22, XP004424628 ISSN: 0022-0248
- SUI Y C ET AL: "STRUCTURE, THERMAL STABILITY, AND DEFORMATION OF MULTIBRANCHED CARBON NANOTUBES SYNTHESIZED BY CVD IN THE AAO TEMPLATE" JOURNAL OF PHYSICAL CHEMISTRY. B, MATERIALS, SURFACES, INTERFACES AND BIOPHYSICAL, WASHINGTON, DC, US, vol. 105, no. 8, 1 mars 2001 (2001-03-01), pages 1523-1527, XP001004463 ISSN: 1089-5647
- KNUTSON T L ET AL: "Reactivity of surfaces and imaging with functional NSOM" ELECTROCHIMICA ACTA, ELSEVIER SCIENCE PUBLISHERS, BARKING, GB, vol. 48, no. 20-22, 30 septembre 2003 (2003-09-30), pages 3229-3237, XP004447020 ISSN: 0013-4686

## Description

L'invention concerne le domaine des procédés de synthèse de structures filamentaires nanométriques et des composants pour l'électronique comportant de telles structures.

On connaît déjà, grâce aux documents « Spin-dependent magnetoresistance and spin-charge séparation in multiwall carbon nanotubes », de X. Hoffer et al., (à paraître dans "Condensed Matter" et disponible sur la page internet http://xxx.lanl.gov/PS_cache/cond-mat/pdf/0303/0303314.pdf) et "Highly ordered carbon nanotube arrays for electrical applications", de J. Li et al. (Applied Physics Letters, Vol. 75, pages 367-369, 19 Juillet 1997), un procédé de synthèse de composants électroniques incorporant des structures filamentaires nanométriques.

On entend par structures filamentaires nanométriques dans l'ensemble du présent document des structures nanométriques formant des fils, bâtonnets, des tubes, etc., c'est-à-dire des structures s'étendant essentiellement dans une direction.

Dans le document cité ci-dessus, les structures filamentaires nanométriques sont des nanotubes de carbone. Le procédé de synthèse de ces nanotubes de carbone, décrit dans l'article de X. Hoffer et al. précité, comporte les opérations consistant à :
- déposer, dans une membrane nanoporeuse, un catalyseur métallique adapté pour pénétrer dans au moins une partie des pores de la membrane nanoporeuse et à
- réaliser une croissance de structures filamentaires sur le catalyseur, dans au moins une partie des pores de la membrane nanoporeuse.

Dans cet article de X. Hoffer et al., les nanotubes de carbone obtenus peuvent être semi-conducteurs ou métalliques. Ce manque de déterminisme est en particulier lié au fait que l'on ne contrôle pas la chiralité des nanotubes au cours de leur synthèse. Ceci constitue un obstacle majeur à l'utilisation des nanotubes de carbone dans les applications électroniques.

Un but de l'invention est de fournir un procédé de synthèse de structures filamentaires nanométriques, permettant de mieux contrôler à la fois leur position, leur taille et leur orientation, notamment leur orientation les uns par rapport aux autres.

Pour arriver à ce but, l'invention fournit le procédé de la Revendication 1.

Grâce à l'invention, les structures filamentaires nanométriques croissent dans les pores de la membrane nanoporeuse. Il est ainsi possible de contrôler la densité, le diamètre, la longueur et l'orientation des structures nanométriques filamentaires. En outre, la texturation, l'orientation et la cristallisation du catalyseur métallique, du fait qu'il est au moins partiellement épitaxié, sur un élément de matériau commun à de nombreux pores, permet de contrôler l'orientation des structures filamentaires nanométriques les unes par rapport aux autres. Dans le cas de structures filamentaires nanométriques constituées de nanotubes de carbone, on contrôle ainsi la chiralité de ces nanotubes.

Le terme épitaxie dans le présent document recouvre les trois propriétés : texturation, orientation et cristallisation.

Le procédé selon l'invention peut comporter en outre, l'une et/ou l'autre des dispositions suivantes :
- on réalise des pores calibrés dans la membrane nanoporeuse ;
- on réalise la membrane nanoporeuse de manière adaptée pour qu'elle s'étende sensiblement dans un plan et on réalise les pores de manière adaptée pour qu'ils soient orientés selon une direction bien déterminée, par exemple sensiblement perpendiculairement ou parallèlement au plan de la membrane ;
- la zone monocristalline de la paroi des pores de la membrane nanoporeuse correspond au fond des pores ;
- la membrane nanoporeuse est réalisée à partir d'un matériau monocristallin ; par exemple, on réalise la membrane nanoporeuse par oxydation anodique d'un substrat monocristallin ;
- on réalise la membrane nanoporeuse dans une couche mince reportée ou déposée sur un substrat monocristallin ; dans ce cas, la couche mince peut aussi être déjà une membrane nonoporeuse, avant son dépôt ou son report sur le substrat monocristallin ;
- on réalise une couche barrière sur le substrat monocristallin, préalablement au report ou au dépôt de la couche mince sur ce substrat monocristallin, le matériau de cette couche barrière formant une barrière de diffusion et étant adapté pour prévenir au moins partiellement la contamination du catalyseur par le matériau constitutif du substrat ;
- on dépose, préalablement à la croissance du catalyseur dans au moins une partie des pores de la membrane, un matériau formant barrière de diffusion, adapté pour prévenir au moins partiellement la contamination du catalyseur par le matériau qui lui est sous-jacent ; la barrière de diffusion est par exemple constituée de tungstène électrodéposé au fond des pores ;
- on dépose, dans au moins une partie des pores, le catalyseur par électrodéposition ;
- on dépose, dans au moins une partie des pores, le catalyseur par dépôt chimique en phase gazeuse ;
- on réalise le dépôt du catalyseur dans au moins une partie des pores de la membrane nanoporeuse, puis on recuit le catalyseur ainsi déposé ; éventuellement, le recuit est réalisé sous champ magnétique ;
- on réalise un composant électronique sur la membrane nanoporeuse ;
- les structures filamentaires nanométriques sont des nanotubes de carbone ;
- le dépôt des structures filamentaires s'effectue par dépôt chimique en phase vapeur ; pour catalyser la croissance des nanotubes de carbone, on peut utiliser un métal de transition, éventuellement associé à une terre rare ; le catalyseur est dans ce cas, essentiellement un corps qui dissout bien le carbone ; il s'agit par exemple du fer, du cobalt, du nickel, du platine, etc ; il peut également s'agir d'un corps composé d'au moins deux de ces constituants ; et
- les structures filamentaires nanométriques sont des nanofils ou des nanobâtonnets ; dans ce cas, le catalyseur est éventuellement un métal de la liste comprenant l'or et l'aluminium.

Selon un autre aspect, l'invention concerne un composant pour l'électronique comportant au moins une structure filamentaire nanométrique obtenue par le procédé selon l'une des revendications précédentes, ce composant comprenant :
- une membrane nanoporeuse dont les pores comportent une zone monocristalline,
- un catalyseur métallique déposé dans au moins une partie des pores de la membrane nanoporeuse, ce catalyseur étant au moins partiellement épitaxié sur la zone monocristalline de la membrane nanoporeuse.

Ce composant peut comporter au moins une partie de la membrane nanoporeuse qui constitue une électrode permettant ainsi d'imposer une tension à au moins une structure filamentaire nanométrique déposée dans une autre partie de la membrane nanoporeuse.

Le composant selon l'invention peut comporter en outre l'une et/ou l'autre des dispositions suivantes :
- il comporte au moins une structure nanométrique filamentaire s'étendant parallèlement au plan du substrat ;
- il comporte une électrode comportant elle-même une extension dans un pore de la membrane nanoporeuse ;
- au moins une structure nanométrique filamentaire est un nanotube de carbone ;
- au moins une structure nanométrique filamentaire est un bâtonnet ou un fil.

Les caractéristiques ci-dessus ainsi que d'autres apparaîtront mieux à la lecture de la description qui suit de modes particuliers d'exécution de l'invention, donnés à titre d'exemples non limitatifs. La description se réfère aux dessins qui l'accompagnent, dans lesquels :
- la figure 1 représente schématiquement un exemple de mode de mise en oeuvre du procédé selon l'invention, dans le cadre de la synthèse de nanotubes de carbone ;
- la figure 2 représente schématiquement un pore comportant un nanotube de carbone obtenu avec le procédé illustré par la figure 1 ;
- la figure 3 représente schématiquement en coupe une membrane nanoporeuse dont les pores sont au moins partiellement tapissés d'une couche barrière sur laquelle est déposé un catalyseur ;
- la figure 4 représente schématiquement le report d'une membrane nanoporeuse sur un substrat, conformément à une variante du procédé selon l'invention ;
- la figure 5 représente schématiquement en coupe une variante de la structure représentée sur la figure 3, dans laquelle la couche barrière a été déposée sur un substrat avant report d'une membrane nanoporeuse conformément aux opérations schématiquement représentées sur la figure 4 ;
- la figure 6 représente schématiquement un exemple de mise en oeuvre du procédé selon l'invention, pour la fabrication d'un composant conforme à l'invention ;
- la figure 7 représente schématiquement, de manière analogue à la figure 6, une variante du procédé représenté sur la figure 6 ;
- la figure 8 représente schématiquement une autre variante du procédé représenté sur les figures 6 et 7 ;
- la figure 9 représente schématiquement un autre exemple de mise en oeuvre du procédé selon l'invention, dans le cadre de la synthèse de nanobâtonnets ;
- la figure 10 représente schématiquement en coupe une portion de membrane nanoporeuse dans laquelle on fait croître un nanobâtonnet au cours de l'exemple de mise en oeuvre du procédé illustré par la figure 9 ; et
- la figure 11 représente schématiquement un four pour la mise en oeuvre d'une variante du procédé selon l'invention.

Des exemples de mise en oeuvre du procédé selon l'invention sont décrits ci-dessous en relation avec deux applications.

Pour la première application, le procédé selon l'invention est mis en oeuvre pour synthétiser des structures filamentaires nanomètriques sous la forme de nanotubes de carbone.

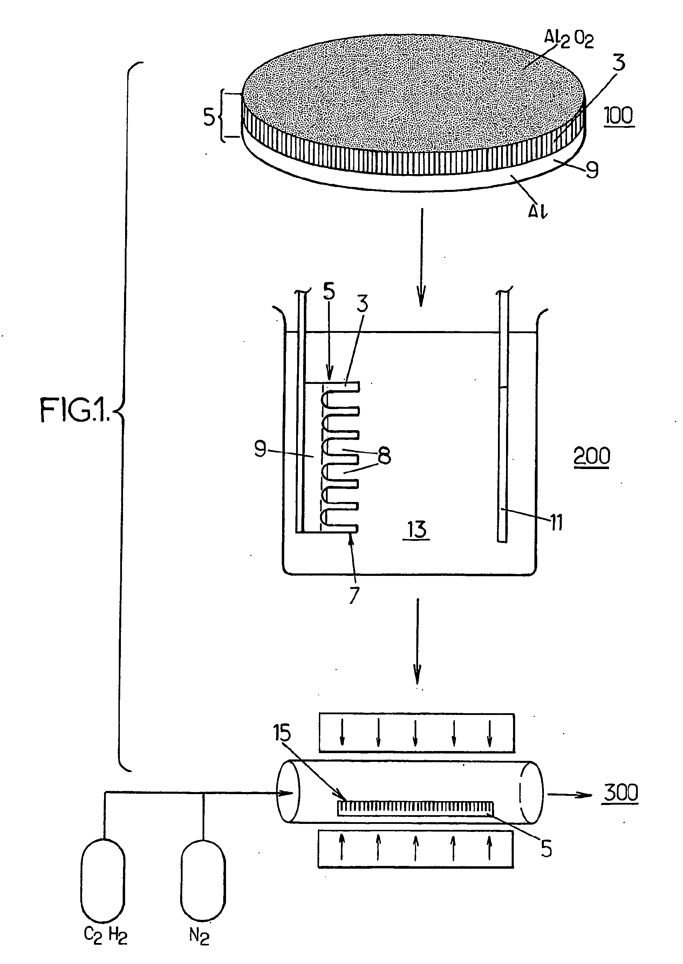

La figure 1 représente un exemple, non limitatif, d'un mode de mise en oeuvre du procédé selon l'invention en relation avec cette première application.

Selon cet exemple, le procédé comporte :
- une étape 100 de réalisation d'une membrane 3 nanoporeuse par anodisation d'un substrat 5 d'aluminium,
- une étape 200 d'électrodéposition d'un métal de transition (Ni, Cr, Co, Fe, etc.) ou de platine, l'un ou l'autre étant éventuellement légèrement allié à une terre rare (Y, Ce, etc.), pour former un catalyseur 7 dans la membrane nanoporeuse 3 obtenue à l'étape précédente (le catalyseur 7 est un élément ou un composé chimique adapté pour dissoudre beaucoup de carbone), et
- une étape 300 de dépôt chimique en phase vapeur de carbone 15 dans les pores 8 de la membrane nanoporeuse 3.

La technique d'anodisation de l'aluminium, mise en oeuvre à l'étape 100, pour obtenir des membranes nanoporeuses est bien connue [voir par exemple les articles de NIELSCH et al., Adv. Mater. 12, 582 (2000) ou J. Magn. Magn. Mat. 249, 234 (2002)]. Cette technique comporte de nombreux avantages : facilité de mise en oeuvre (avec seulement un potentiostat classique), obtention d'alumine (Al₂O₃) qui est un matériau remarquable du point de vue de la résistance à la chaleur et du point de vue des propriétés diélectriques, etc.

Cette technique permet de réaliser au laboratoire des membranes nanoporeuses 3 avec un réseau de pores 8 dont le diamètre peut aller de 5 à 100 nanomètres, sur une longueur variant entre 0,5 micron et 50 microns. Typiquement, pour des pores de 60 nanomètres de diamètre, la densité est de l'ordre de 10¹⁰ pores par cm².

Le substrat 5 est ici constitué d'aluminium monocristallin.

Pour obtenir des nanotubes de carbone comportant un petit nombre de feuillets, voire un seul feuillet, on réalise des membranes nanoporeuses 3 avec des pores 8 de l'ordre de 5 nanomètres de diamètre, voire moins, avec une longueur inférieure au micron. Pour réaliser des composants électroniques, on cherche à réduire la densité des pores.

Notons que la chiralité des nanotubes de carbone est conservée tant que le nombre de feuillets reste inférieur à environ 5 ce qui signifie qu'il faut obtenir des nanopores de 5 à 7 nanomètres de diamètre pour obtenir des nanotubes dont la chiralité est déterminée et rendre ainsi les nanotubes de carbone obtenus d'autant plus intéressants pour les applications en électronique.

Notons aussi que pour les applications en électronique, l'anodisation du substrat d'aluminium 5 pour former la membrane nanoporeuse 3 se fait avantageusement avec un masque afin de dessiner des zones nanostructurées comportant des nanotubes de carbone et des zones plus spécifiquement dédiées à la réalisation de connexions électriques.

L'étape 200 d'électrodéposition du catalyseur est réalisée en appliquant un potentiel entre l'aluminium 9 situé sous la membrane nanoporeuse 3 et une contre électrode 11 dans un bain électrolytique 13. L'étape 200 d'électrodéposition du catalyseur est réalisée en jouant avec les paramètres de croissance électrolytique (potentiel de dépôt, concentration en catalyseurs du bain, pH du bain, fréquence du potentiel alternatif de dépôt, etc.). Il est alors possible d'obtenir des monocristaux de catalyseur. En effet, la présence de l'aluminium monocristallin du substrat 5 avant anodisation permet d'initier, dans une certaine mesure, une épitaxie au cours de l'électrodéposition.

L'influence de la structure cristalline du substrat 5 sur la structure cristalline des métaux ou semiconducteurs électrodéposés sur ce substrat 5 a été démontrée. Par exemple, dans le document de M. K. Kleinert et al., Electrochemica Acta, 46 (2001), 3129, le cobalt électrodéposé sur l'or (Au[100]) acquiert une structure régulière qui reflète la symétrie du substrat 5. Dans le document de P. Evanes et al., JMMM 260 (2003), 467, l'épitaxie par électrodéposition du nickel sur un substrat d'arséniure de Gallium est maintenue sur une épaisseur de 10 à 120 nm.

Eventuellement, l'électrodéposition du catalyseur est effectuée après réduction des résidus d'oxyde formés au cours de l'étape 101 d'anodisation de l'aluminium monocristallin du substrat 5, réalisée pour obtenir la membrane nanoporeuse 3. Une calibration préalable permet de contrôler le nombre d'atomes de catalyseur déposé dans chaque pore.

L'électrodéposition est une technique de dépôt rapide et qui permet de déposer le catalyseur 7 au fond des pores 8, tout en conservant un matériau déposé bien texturé.

Eventuellement aussi, l'électrodéposition peut être réalisée sous champ magnétique afin de favoriser l'obtention d'un axe de facile aimantation et ainsi agir sur le contrôle de la chiralité, lors de la croissance ultérieure des nanotubes de carbone.

Après l'étape 200 d'électrodéposition du catalyseur, le procédé selon l'invention comporte éventuellement une étape de recuit entre environ 500 et 630°C, voire moins.

Le fait d'avoir, après électrodéposition, un catalyseur emprisonné dans les pores 8 de la membrane nanoporeuse 3, plutôt que sous forme de petites particules à la surface d'un substrat, permet d'effectuer des recuits de cristallisation/épitaxie à moyenne température, tout en évitant la diffusion superficielle qui favoriserait la coalescence du catalyseur.

Le procédé selon l'invention permet donc à la fois de maintenir la taille nanométrique du catalyseur et de le structurer pendant le dépôt et/ou par recuit.

L'étape 300 de dépôt de carbone 15 et de croissance de nanotubes de carbone est effectuée par dépôt chimique en phase vapeur à faible vitesse de croissance. Ce type de technique permet un meilleur contrôle de la qualité cristalline des nanotubes de carbone. En particulier, le dépôt chimique en phase vapeur assisté par plasma en condition de résonance cyclotronique électronique permet de travailler à basse pression et donc de bien contrôler la vitesse de dépôt.

Typiquement, le dépôt de nanotubes de carbone est réalisé en utilisant l'acétylène comme gaz précurseur et la température au cours du dépôt est fixée autour de 620°C.

Il est aussi possible d'éliminer l'aluminium après les étapes 100 d'anodisation et 200 d'électrodéposition. Ainsi, la température, notamment au cours de la croissance des nanotubes de carbone, peut être élevée au-delà de 650°C. Ceci peut être également obtenu en alliant l'aluminium, par dépôt et diffusion, avec un métal plus réfractaire, après anodisation et électrodéposition.

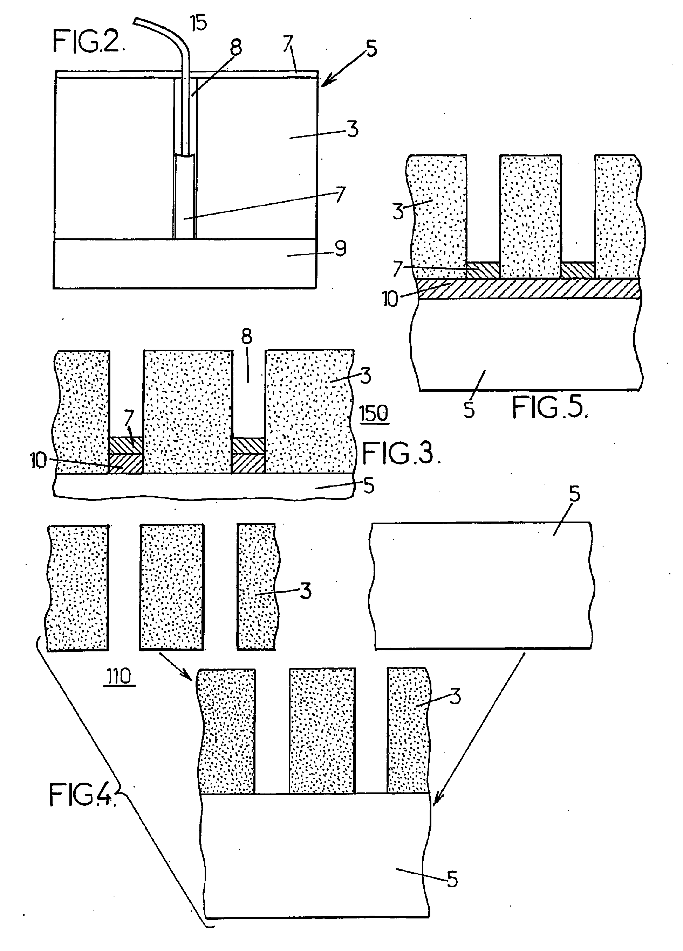

Les nanotubes de carbone 15 obtenus à l'issue du procédé selon l'invention tel que décrit ci-dessus sont orientés du fait de leur croissance catalysée par le catalyseur 7 qui est lui-même épitaxié sur le matériau monocristallin du substrat 5 et de la couche nanoporeuse 3 (voir figure 2). Leur chiralité est bien déterminée.

Bien entendu, le mode de mise en oeuvre du procédé selon l'invention décrit ci-dessus peut comporter de nombreuses variantes.

Selon une variante, représentée sur la figure 3, une étape 150 de dépôt d'une couche barrière 10 est réalisée entre l'étape 100 d'anodisation et l'étape 200 d'électrodéposition du catalyseur 7. Cette couche barrière 10 est destinée à empêcher la contamination du catalyseur 7 par diffusion d'éléments provenant du substrat 5, notamment lorsque l'on a recours à une étape de recuit pour favoriser l'épitaxie du catalyseur 7 au fond des pores 8. Cette couche barrière 10 est par exemple constituée de tungstène électrodéposé.

Selon une autre variante représentée sur la figure 4, une membrane nanoporeuse 3 est formée, au cours d'une étape 100 par anodisation, sur la totalité de l'épaisseur d'une couche d'aluminium. Puis cette membrane nonaporeuse est reportée, au cours d'une étape 110, sur un substrat d'aluminium 5, ou plus généralement un substrat métallique monocristallin

Selon encore une autre variante, représentée sur la figure 5, une étape 160 d'électrodéposition d'une couche barrière 10 sur un substrat d'aluminium 5, ou plus généralement un substrat métallique monocristallin, est réalisée, avant qu'une membrane nanoporeuse 3 anodisée sur la totalité de son épaisseur ne soit reportée, au cours d'une étape 110 telle que celle mentionnée ci-dessus, sur le substrat 5, du côté où la couche barrière 10 a été préalablement déposée. Le catalyseur 7 est ensuite déposé au cours d'une étape 200, comme indiqué ci-dessus.

En outre, d'autres matériaux que l'alumine peuvent être obtenus pour la membrane nanoporeuse 3. Il est aussi possible de réaliser l'alumine de la membrane nanoporeuse 3 à partir d'une couche d'aluminium épitaxiée sur un substrat isolant tel que le nitrure d'aluminium (AIN, lui-même éventuellement épitaxié sur du silicium), du saphir, de l'oxyde de magnésium (MgO), etc.

De même, du choix de l'orientation du substrat dépend l'objectif visé, c'est-à-dire la chiralité des nanotubes de carbone que l'on souhaite obtenir.

En outre, le dépôt des nanotubes de carbone peut faire l'objet de nombreuses variantes. Ainsi, il est possible d'obtenir une bonne qualité cristalline des nanotubes de carbone à partir d'un dépôt chimique en phase vapeur par filament chaud. Le gaz précurseur peut être du méthane ou tout autre gaz carboné connu de l'homme de l'art. La température de dépôt peut aussi varier, celle-ci étant optimisée notamment en fonction du catalyseur utilisé.

Un des avantages majeurs du procédé selon l'invention repose sur le fait que l'on effectue une croissance contrôlée de nanotubes de carbone à partir de nanocristaux de catalyseur tous identiques en taille et en orientation, dans des pores de dimension calibrée, de manière à obtenir des nanotubes aussi identiques, en particulier du point de vue de leur diamètre et de leur chiralité.

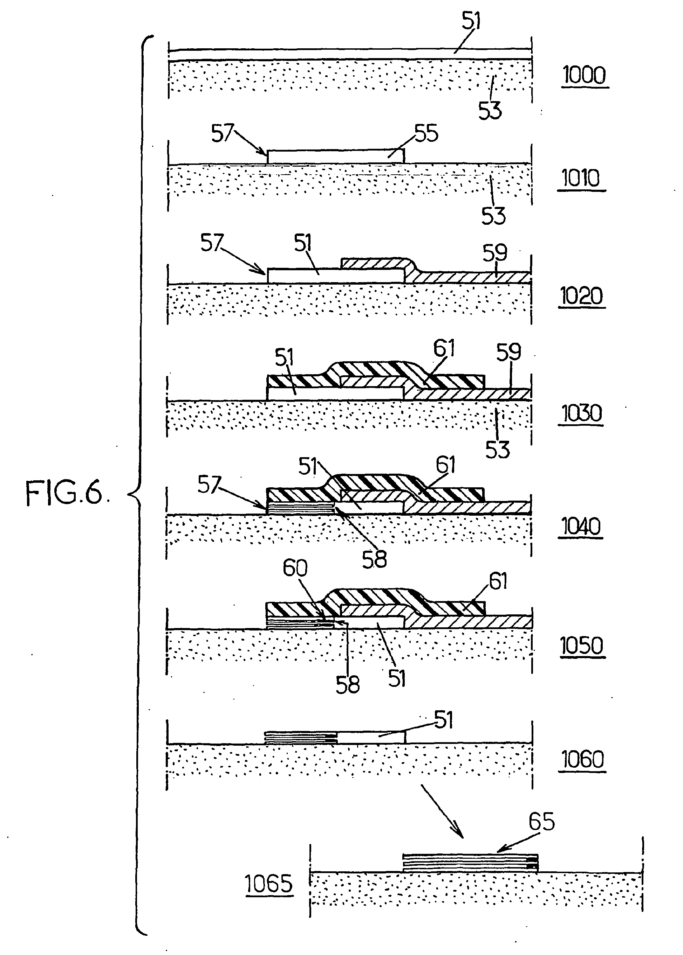

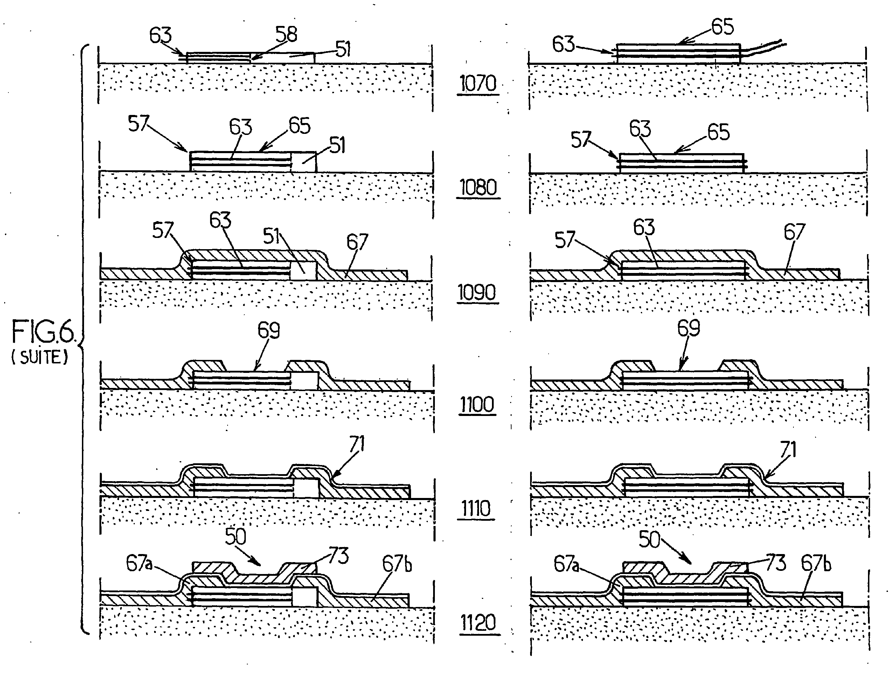

Le contrôle de la géométrie et des propriétés, notamment la chiralité, des nanotubes de carbone, grâce au procédé selon l'invention, permet de réaliser, de manière reproductible, des composants électroniques (transistors, diodes électroluminescente, capteurs, actuateurs, etc.). Un exemple de composant électronique conforme à la présente invention est décrit ci-dessous en relation avec la figure 6. Il s'agit d'un transistor 50 à effet de champ.

La réalisation de ce transistor 50 à effet de champ passe par :
- une étape 1000 d'épitaxie d'une couche d'aluminium 51 sur un substrat isolant monocristallin 53 (AIN, saphir, MgO, etc.) ; éventuellement, le substrat monocristallin 53 est remplacé par une couche mince isolante (d'AlN, de saphir, de MgO, etc.) épitaxiée sur un substrat, tel que du silicium, lui-même monocristallin et adapté pour l'épitaxie de cette couche mince ;
- une étape 1010 de gravure de bandes 55 gravées dans l'épaisseur de la couche d'aluminium 51 ; l'orientation de ces bandes 55 dans le plan du substrat 53 est choisie de manière à favoriser une orientation latérale particulière des flancs 57 de l'aluminium, afin d'optimiser l'épitaxie des nanocristaux de catalyseur par électrodéposition ;
- une étape 1020 de dépôt d'une électrode 59 sur la couche d'aluminium 51 épitaxiée ; cette électrode 59 est nécessaire pour l'oxydation anodique et l'électrodéposition ultérieures ;
- une étape 1030 d'encapsulation de l'ensemble constitué de la couche d'aluminium épitaxiée 51 et de son électrode 59, dans un matériau 61 isolant, tel qu'un polymère ou de la silice, ou toute autre couche mince isolante ; ce matériau isolant 61 est nécessaire pour isoler le dessus de la couche d'aluminium 51 épitaxiée et son électrode 59 de la solution électrolytique utilisée pour l'oxydation anodique et l'électrodéposition ultérieures ;
- une étape 1040 d'oxydation anodique du flanc 57 non protégé par le matériau isolant 61 d'encapsulation, de la couche d'aluminium 51 épitaxiée ; cette étape est réalisée conformément à l'étape 100 décrite ci-dessus ; elle donne lieu à la formation d'une interface Al₂O₃/Al 58;
- une étape 1050 d'électrodéposition d'un catalyseur 60 à l'interface 58 cette étape est aussi réalisée conformément à l'opération 200 décrite ci-dessus ;
- une étape 1060 d'élimination de la couche de matériau isolant 61 d'encapsulation et de l'électrode 59 ;
- une éventuelle étape 1065 pour éliminer l'aluminium 51, notamment si l'on souhaite ultérieurement procéder à la croissance de nanotubes de carbone 63 à une température supérieure à 650°C ;
- une étape 1070 de croissance des nanotubes de carbone 63 par dépôt chimique en phase vapeur en mettant en oeuvre l'opération 300 décrite ci-dessus ;
- une étape 1080 de réalisation d'îlots 65 dans les bandes 55, maintenant constituées de l'alumine formée par oxydation de l'aluminium épitaxié (il peut éventuellement rester de l'aluminium 51) ; ces bandes 55 -comportent au moins un flanc 57 pourvu de nanotubes de carbone 63 ; éventuellement, on procède à une surgrayure de l'alumine pour que les nanotubes de carbone 63 dépassent sur les flancs 57 ;
- une étape 1090 de dépôt d'un métal 67, typiquement du titane, pour réaliser un contact ohmique côté drain (sur la couche d'aluminium 51 épitaxiée ou avec les nanotubes de carbone 63 affleurant), et côté source (avec les nanotubes de carbone 63 affleurant, sur le flanc 57 ;
- une étape 1100 de gravure d'un canal 69 ;
- une étape 1110 de dépôt d'une couche mince d'isolant 71, typiquement SiO₂ ou un autre matériau à plus forte constante diélectrique tel que TiO₂ ; et
- une étape 1120 de dépôt et de gravure d'une grille 73, de manière à légèrement déborder sur les électrodes de source 67a et de drain 67b.

Le procédé de réalisation du transistor 50, décrit ci-dessus, peut comporter de nombreuses variantes.

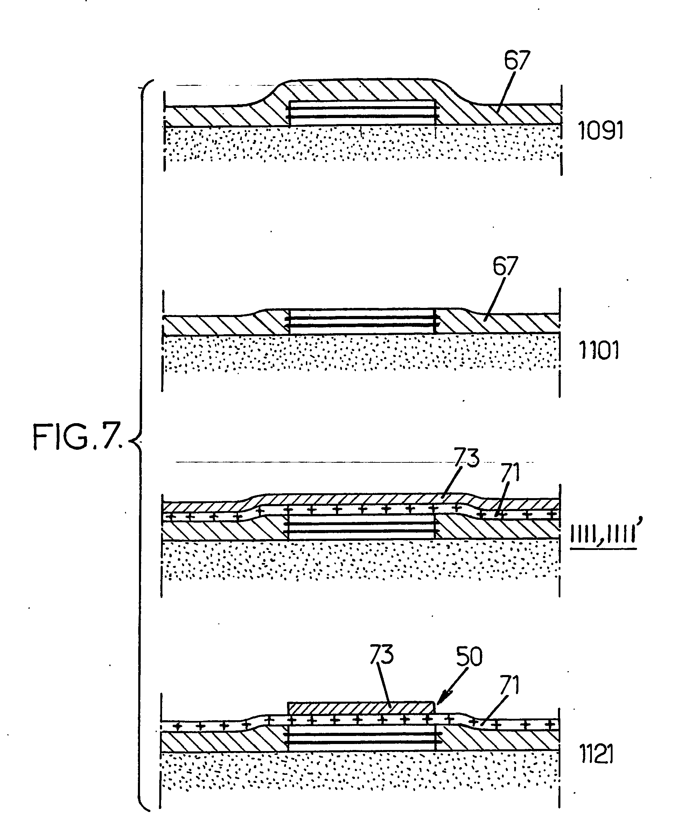

En particulier, comme représenté sur la figure 7, on peut procéder à la réalisation d'un transistor 50 par auto alignement.

Par exemple, les étapes 1090 à 1120 décrites ci-dessus sont remplacées par les étapes 1091 à 1121 suivantes.

Au cours d'une étape 1091, on procède au dépôt d'un métal 67, comme pour l'étape 1090 ci-dessus.

Au cours d'une étape 1101, on procède à une gravure par planarisation de la couche de métal 67, jusqu'à atteindre l'alumine nanoporeuse. Cette gravure est réalisée selon un procédé bien connu de l'Homme du métier, dit procédé CMP (de l'expression anglo-saxonne "Chemical Mechanical Polishing").

Sont ensuite déposés au cours d'étapes 1111, 1111', les dépôts successifs d'une couche de matériau diélectrique 71 et d'une couche de métal 73.

Au cours d'une étape 1121, la couche de métal 73 est gravée pour former la grille du transistor 50.

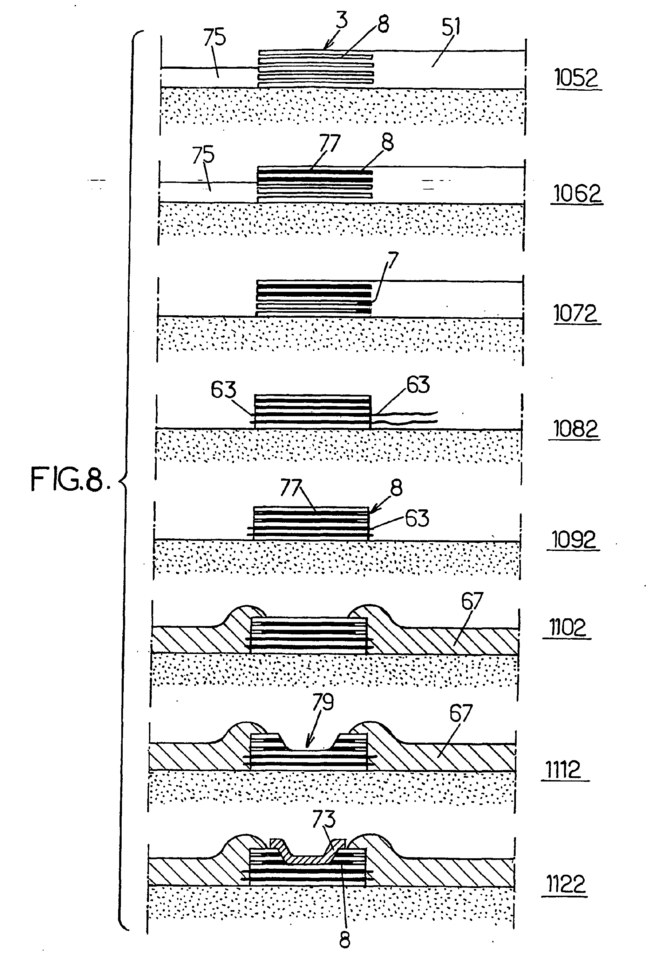

Selon une autre variante représentée sur la figure 8, on remplace les étapes 1050 et suivantes du mode de réalisation illustré par la figure 6, par les étapes suivantes.

Au cours d'une étape 1052, une résine 75 est déposée sur une épaisseur correspondant à une portion de la hauteur de la membrane nanoporeuse 3.

Au cours d'une étape 1062, on effectue un remplissage sélectif des pores 8 superficiels, c'est-à-dire non protégés par la résine 75, avec un métal non catalyseur de la croissance de nanotubes de carbone. Au cours d'une étape 1072, la résine 75 est éliminée et le catalyseur 7 est électro-déposé, par exemple de la manière indiquée en relation avec les étapes 1030 à 1060 décrites ci-dessus.

Au cours d'une étape 1082, on procède à la croissance des nanotubes de carbone 63, par exemple comme à l'étape 1070 décrite ci-dessus.

Au cours d'une étape 1092, on procède à la gravure des nanotubes de carbone 63 et à la sous gravure du métal 77 dans les pores 8.

Au cours d'une étape 1102, des contacts de source et de drain sont déposés, par exemple en procédant à un dépôt de métal et à une gravure, de manière analogue aux étapes 1090 et 1100 décrites ci-dessus.

Au cours d'une étape 1112, on ouvre un puits 79 dans l'alumine pour, au cours d'une étape 1122, de dépôt d'une grille 73, établir un contact avec le métal 77 des pores 8.

Pour la deuxième application, le procédé selon l'invention est mis en oeuvre pour synthétiser des structures filamentaires nanomètriques sous la forme de nanofils ou de nanobâtonnets. Ces structures sont également connues de l'homme du métier sous le terme « whiskers » (voir par exemple le document FR-A-2 658 839).

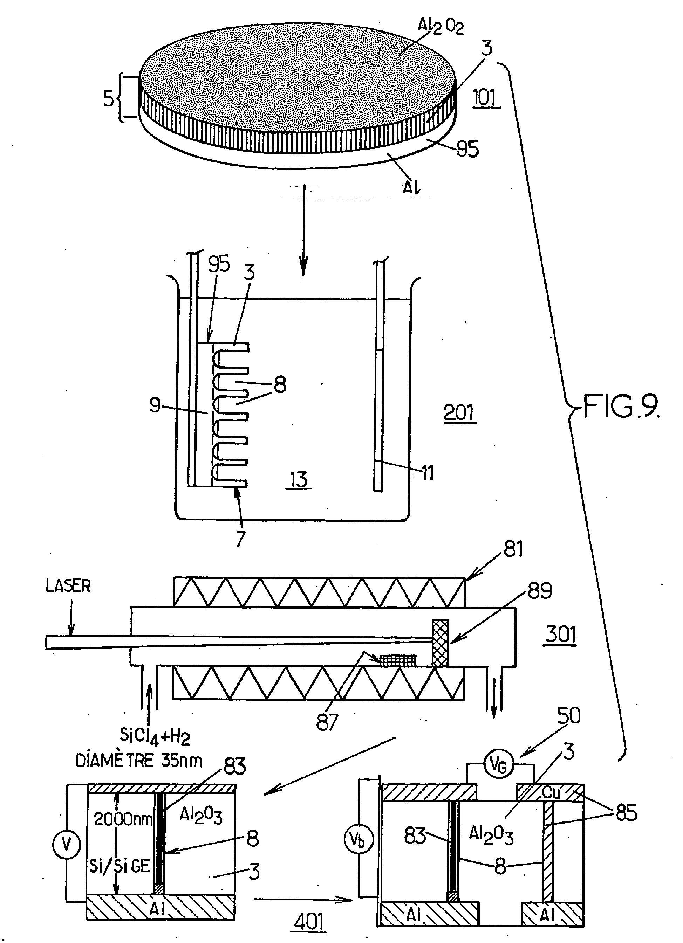

La figure 9 représente un exemple, non limitatif, d'un mode de mise en oeuvre du procédé selon l'invention en relation avec cette deuxième application.

Pour cette deuxième application, le procédé comporte :
- une étape 101 de réalisation d'une membrane 3 nanoporeuse par anodisation partielle d'un substrat 5 d'aluminium monocristallin (ou plus généralement d'un métal monocristallin) ;
- une étape 201 d'électrodéposition d'un métal tel que de l'or pour former un catalyseur 7, dans la membrane nanoporeuse 3 obtenue à l'étape précédente, et
- une étape 301 de croissance d'une multicouche de silicium et de germanium par dépôt chimique en phase vapeur assisté par ablation laser, dans un four 81 sous un flux d'un mélange gazeux constitué de SiCl₄ et H₂. Cette multicouche constituant, à l'intérieur d'un pore 8, un nanobâtonnet 83 monocristallin.

En outre, pour réaliser un composant électronique, on dépose, au cours d'une étape 401, par exemple par électrodéposition, un métal conducteur 85 tel que du cuivre dans un pore 8 voisin d'un nanobâtonnet 83 réalisé au cours de l'étape 301.

L'étape 101 d'anodisation est analogue à celle mise en oeuvre pour la première application. Elle en conserve évidemment les mêmes avantages.

L'étape 201 d'électrodéposition est analogue à celle mise en oeuvre pour la première application, à la différence que la nature du catalyseur électrodéposé peut être différente. Elle en conserve néanmoins les mêmes avantages.

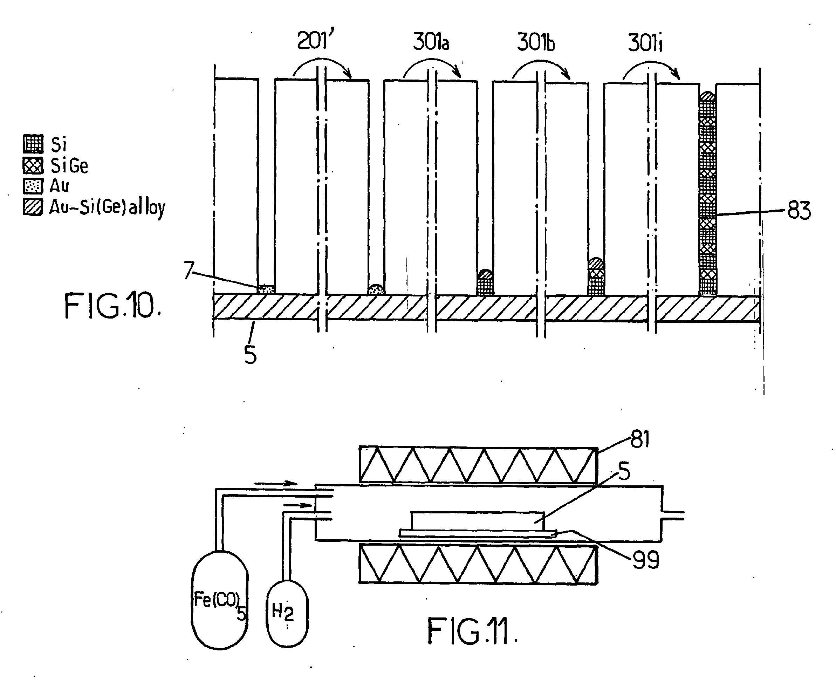

Comme représenté sur la figure 10, on procède éventuellement au cours d'une étape 201' à un recuit du catalyseur 7 déposé à l'étape 201 qui permet d'obtenir l'épitaxie de celui-ci sur le substrat 5.

L'étape 301 de croissance de la multicouche de silicium et de germanium consiste en une succession de séquences 301a, 301b, ..., 301i de dépôt de silicium, puis de silicium-germanium. A cette fin, un creuset de silicium 87 et une cible 89 de germanium sont placés dans le four 81. Pendant les séquences de dépôt de silicium et de silicium-germanium, un mélange gazeux de SiCl₄ et de H₂ balaye le four 81 et entraîne les vapeurs de silicium et de silicium-germanium formées à partir du creuset 87 de silicium et de la cible 89 de germanium. Au cours de chaque séquence de dépôt de silicium, seul le silicium est vaporisé. Au cours de chaque séquence de dépôt de silicium-germanium du germanium est pulvérisé par ablation laser, en plus de l'évaporation du silicium. On se base pour la mise en oeuvre de cette étape de croissance 301, dans cette variante du procédé selon l'invention, sur l'article de Y. Wu et al., Nanoletters 2, 83 (2002). L'ablation laser constitue une source de vapeur pulsée programmable, qui permet la croissance des nanobâtonnets 83 bloc par bloc avec un profil de composition très bien défini sur toute la hauteur de chaque nanobâtonnet 83. On réalise ainsi des nanobâtonnets 83 monocristallins, par exemple de 2 microns de hauteur et 35 nanomètres de diamètre, avec un super-réseau Si/SiGe. De telles hétérostructures unidimensionnelles sont d'un grand intérêt pour les applications telles que les dispositifs émetteurs de lumière et les dispositifs thermoélectriques.

L'étape 401 consiste, par exemple, à électrodéposer du cuivre dans un pore voisin du nanobâtonnet 83 réalisé au cours de l'étape 301, par exemple par des techniques de masquage et microlithographie (éventuellement électronique) connues de l'Homme du Métier.

On obtient ainsi une structure dans laquelle un potentiel peut être appliqué entre l'aluminium du substrat 5 sous-jacent et le cuivre 85 déposé sur la membrane, pour former des contacts de source et de drain d'un transistor 50, tandis que le cuivre dans le pore voisin forme la grille de ce transistor 50.

Pour cette deuxième application, on peut avoir les mêmes variantes que celles du procédé selon l'invention mis en oeuvre dans la première application. C'est-à-dire en particulier l'utilisation d'une couche barrière et/ou d'un report de membrane nanoporeuse comme illustré sur les figures 3 à 5.

L'invention décrite ci-dessus peut faire l'objet de nombreuses variantes. En particulier, des étapes des différents modes de mise en oeuvre décrits ci-dessus peuvent être combinées.

En outre, le dépôt de particules catalytiques dans les pores 8 de la membrane 3 nanoporeuse peut s'effectuer par tout autre moyen connu de l'Homme de l'Art. A titre d'exemple, on citera le dépôt chimique en phase gazeuse (CVD en anglais). Dans cette technique, on utilise un métal carbonyle, tel que Ni(CO)₅, ou Fe(CO)₅, que l'on vient décomposer dans un four 81, où l'on a positionné la membrane 3 sur un porte échantillon 99 (voir figure 11). Par exemple, pour Fe(CO)₅, là décomposition s'effectue vers 250°C. On peut aussi utiliser un précurseur tel que le fer dicyclopentadienyl (ferrocène : Fe(Cp)₂), qui se décompose à plus haute température (≈600-800°C) . Le métal (Ni ou Fe par exemple) se dépose alors dans des pores 8.

## Revendications

1. Procédé de synthèse de composants électroniques (50) incorporant des structures filamentaires nanométriques " (63) dans lequel :
- on réalise une membrane (3) nanoporeuse par oxydation anodique d'un substrat (5) monocristallin,
- on dépose, dans la membrane (3) nanoporeuse, un catalyseur (7) métallique adapté pour pénétrer dans au moins une partie des pores (8) de la membrane (3) nanoporeuse et
- on réalise une croissance de structures filamentaires (63) sur le catalyseur (7), dans au moins une partie des pores (8) de la membrane (3) nanoporeuse,
**caractérisé par le fait que** l'on prépare la membrane (3) nanoporeuse de manière adaptée pour que la paroi des pores (8) comporte une zone monocristalline et que l'on épitaxie au moins partiellement le catalyseur (7) sur cette zone monocristalline et sur le substrat (5) monocristallin commun à plusieurs pores (8).

2. Procédé selon la revendication 1, dans lequel on réalise des pores (8) calibrés dans la membrane (3) nanoporeuse.

3. Procédé selon l'une des revendications précédentes, dans lequel on réalise la membrane (3) nanoporeuse de manière adaptée pour qu'elle s'étende sensiblement dans un plan et on réalise les pores (8) de manière adaptée pour qu'ils soient orientés sensiblement perpendiculairement au plan de la membrane (3).

4. Procédé selon l'une des revendications 1 et 2, dans lequel on réalise la membrane (3) nanoporeuse de manière adaptée pour qu'elle s'étende sensiblement dans un plan et on réalise les pores (8) de manière adaptée pour qu'ils soient orientés sensiblement parallèlement au plan de la membrane (3).

5. Procédé selon l'une des revendications précédentes, dans lequel la zone monocristalline de la paroi des pores (8) de la membrane nanoporeuse (3) correspond au fond des pores (8).

6. Procédé selon l'une des revendications 1 à 5, dans lequel on réalise la membrane (3) nanoporeuse dans une couche mince reportée ou déposée sur un substrat (5) monocristallin.

7. Procédé selon la revendication 7, dans lequel on réalise une couche barrière (10) sur le substrat (5) monocristallin, préalablement au report ou au dépôt de la couche mince sur ce substrat (5) monocristallin, le matériau de cette couche barrière (10) formant une barrière de diffusion et étant adapté pour prévenir au moins partiellement la contamination du catalyseur (7) par le matériau constitutif du substrat (5).

8. Procédé selon l'une des revendications précédentes, dans lequel on dépose, préalablement à la croissance du catalyseur (7) dans au moins une partie des pores (8) de la membrane (3), un matériau formant barrière de diffusion, adapté pour prévenir au moins partiellement la contamination du catalyseur (7) par le matériau qui lui est sous-jacent.

9. Procédé selon l'une des revendications précédentes, dans lequel on dépose, dans au moins une partie des pores (8), le catalyseur (7) par électrodéposition.

10. Procédé selon l'une des revendications précédentes, dans lequel on dépose, dans au moins une partie des pores (8), le catalyseur (7) par dépôt chimique en phase gazeuse.

11. Procédé selon l'une des revendications précédentes, dans lequel on réalise le dépôt du catalyseur (7) dans au moins une partie des pores (8) de la membrane (3) nanoporeuse, puis on recuit le catalyseur (7) ainsi déposé.

12. Procédé selon la revendication 12, dans lequel le recuit est réalisé sous champ magnétique.

13. Procédé selon l'une des revendications précédentes, dans lequel on réalise un composant (50) électronique sur la membrane nanoporeuse.

14. Procédé selon l'une des revendications précédentes, dans lequel les structures filamentaires (63) nanométriques sont des nanotubes de carbone.

15. Procédé selon la revendication 15, dans lequel le catalyseur (7) comprend un métal de transition.

16. Procédé selon l'une des revendications précédentes, dans lequel le dépôt des structures filamentaires (63) s'effectue par dépôt chimique en phase vapeur.

17. Procédé selon l'une des revendications précédentes, dans lequel les structures filamentaires (63) nanométriques sont des nanofils ou des nanobâtonnets.

18. Procédé selon la revendication 18, dans lequel le catalyseur (7) est un métal de la liste comprenant l'or et l'aluminium.

19. Composant pour l'électronique comportant au moins une structure filamentaire (63) nanométrique obtenue par le procédé selon l'une des revendications précédentes, ce composant (50) comprenant :
- une membrane nanoporeuse dont les pores (8) comportent une zone monocristalline,
- un catalyseur (7) métallique déposé dans au moins une partie des pores (8) de la membrane (3) nanoporeuse, au moins partiellement épitaxié sur la zone monocristalline de la membrane (3) nanoporeuse et sur le substrat (5) monocristallin commun à plusieurs pores (8).

20. Composant selon la revendication 20, dans lequel au moins une partie de la membrane (3) nanoporeuse constitue une électrode (59) permettant d'imposer une tension à au moins une structure filamentaire (63) déposée dans une autre partie de la membrane (3) nanoporeuse.

21. Composant selon l'une des revendications 20 et 21 reposant sur un substrat (5) et comportant au moins une structure nanométrique filamentaire (63) s'étendant parallèlement au plan du substrat (5).

22. Composant selon l'une des revendications 20 à 22, comportant une électrode (85) comportant elle-même une extension dans un pore (8) de la membrane nanoporeuse (3).

23. Composant selon l'une des revendications 20 à 23, dans lequel au moins une structure nanométrique filamentaire (63) est un nanotube de carbone.

24. composant selon l'une des revendications 20 à 24, dans lequel au moins une structure nanométrique filamentaire (63) est un bâtonnet ou un fil.

## Claims

1. A method of synthesizing electronic components (50) incorporating nanoscale filamentary structures (63), in which:
- a nanoporous membrane (3) is made by anodic oxidation of a single-crystal substrate (5)
- in the nanoporous membrane (3), a metal catalyst (7) suitable for penetrating into at least some of the pores (8) of the nanoporous membrane (3) is deposited; and
- a filamentary structures (63) growing is performed on the catalyst (7), in at least some of the pores (8) in the nanoporous membrane (3),
the method being **characterized by** the fact that it comprises the preparation of the nanoporous membrane (3) in a manner suitable for ensuring that the wall of the pores (8) includes a single-crystal zone, and growing at least some of the catalyst (7) epitaxially on this single-crystal zone and onto the single-crystal substrate (5) common to various pores (8).

2. A method according to claim 1, in which calibrated pores (8) are made in the nanoporous membrane (3).

3. A method according to any of the preceding claims, in which the nanoporous membrane (3) is made in a manner suitable for ensuring that it extends substantially in a plane, and the pores (8) are made in a manner suitable for ensuring they are oriented substantially perpendicularly to the plane of the membrane (3).

4. A method according to any of the claims 1 and 2, in which the nanoporous membrane (3) is made in a manner suitable for ensuring that it extends substantially in a plane, and the pores (8) are made in a manner suitable for ensuring they are oriented substantially parallel to the plane of the membrane (3).

5. A method according to any of the preceding claims, in which the single-crystal zone of the wall of the pores (8) of the nanoporous membrane (3) corresponds to the bottom of the pores (8).

6. A method according to any of the claims 1 to 5, in which the nanoporous membrane (3) is made in a thin layer transferred or deposited onto a single-crystal substrate (5).

7. A method according to claim 6, in which a barrier layer (10) is made on the single-crystal substrate (5), prior to transferring or depositing the thin layer onto this single-crystal substrate (5), the material of this barrier layer (10) forming a diffusion barrier and being suitable for preventing the catalyst (7), at least in part, from being contaminated by the material constituting the substrate (5).

8. A method according to any of the preceding claims, in which, prior to growing the catalyst (7) in at least some of the pores (8) of the membrane (3), a diffusion barrier forming material is deposited that is suitable for preventing the catalyst (7), at least in part, from being contaminated by the material underlying it.

9. A method according to any of the preceding claims, in which the catalyst (7) is deposited in at least some of the pores (8) by electroplating.

10. A method according to any of the preceding claims, in which the catalyst (7) is deposited in at least some of the pores (8) by chemical gas deposition.

11. A method according to any of the preceding claims, in which the catalyst (7) is deposited in at least some of the pores (8) of the nanoporous membrane (3), and then the catalyst (7) as deposited in this way is annealed.

12. A method according to claim 11, in which annealing is performed under a magnetic field.

13. A method according to any of the preceding claims, in which an electronic component (50) is made on the nanoporous membrane (3).

14. A method according to any of the preceding claims, in which the nanoscale filamentary structures (63) are carbon nanotubes.

15. A method according to claim 14, in which the catalyst (7) comprises a transition metal.

16. A method according to any of the preceding claims, in which the filamentary structures (63) are deposited by chemical vapor deposition.

17. A method according to any of the preceding claims, in which the nanoscale filamentary structures (63) are nanowires or nanorods.

18. A method according to claim 17, in which the catalyst (7) is a metal from the list comprising gold and aluminum.

19. A component for electronics including at least one nanoscale filamentary structure (63) obtained by the method according to any of the preceding claims, the component (50) comprising:
- a nanoporous membrane (3) in which the pores (8) include a single-crystal zone, and
- a metallic catalyst (7) deposited in at least some of the pores (8) of the nanoporous membrane (3), at least part of the catalyst (7) being grown epitaxially on the single-crystal zone of the nanoporous membrane (3) and onto the single-crystal substrate (5) common to various pores (8).

20. A component according to claim 19, in which at least a portion of the nanoporous membrane (3) constitutes an electrode (59) enabling a voltage to be imparted to at least one filamentary structure (63) deposited in another portion of the nanoporous membrane (3).

21. A component according to any of the claims 19 and 20, lying on a substrate (5) and including at least one filamentary nanoscale structure (63) extending parallel to the plane of the substrate (5).

22. A component according to any of the claims 19 to 21, including an electrode (85) itself having an extension in a pore (8) of the nanoporous membrane (3).

23. A component according to any of the claims 19 to 22, in which at least one filamentary nanoscale structure (63) is a carbon nanotube.

24. A component according to any of the claims 19 to 23, in which at least one filamentary nanoscale structure (63) is a rod or a wire.

## Patentansprüche

1. Syntheseverfahren für elektronische Komponenten (50), die nanoskalige faserige Strukturen (63) einbeziehen, in dem:
- eine nanoporöse Membran (3) durch anodische Oxidation eines monokristallinen Substrats (5) hergestellt wird,
- in der nanoporösen Membran (3) ein metallischer Katalysator (7) aufgetragen wird, der dafür eingerichtet ist, wenigstens in einen Teil der Poren (8) der nanoporösen Membran (3) einzudringen, und
- ein Wachstum von faserigen Strukturen (63) auf dem Katalysator (7) in wenigstens einem Teil der Poren (8) der nanoporösen Membran (3) realisiert wird,
**dadurch gekennzeichnet, dass** die nanoporöse Membran (3) auf geeignete Weise vorbereitet wird, damit die Wand der Poren (8) eine monokristalline Zone umfasst und dass wenigstens teilweise der Katalysator (7) auf diese monokristalline Zone und auf das mehreren Poren (8) gemeinsame monokristalline Substrat (5) epitaxiert wird.

2. Verfahren nach Anspruch 1, in dem in der nanoporösen Membran kalibrierte Poren (8) ausgeführt werden.

3. Verfahren nach einem der vorhergehendenden Ansprüche, in dem die nanoporöse Membran (3) auf geeignete Weise ausgeführt wird, damit sie sich im Wesentlichen in einer Ebene erstreckt, und die Poren (8) auf geeignete Weise ausgeführt werden, damit sie im Wesentlichen senkrecht zur Ebene der Membran (3) ausgerichtet sind.

4. Verfahren nach einem der Ansprüche 1 und 2, in dem die nanoporöse Membran (3) auf geeignete Weise ausgeführt wird, damit sie sich im Wesentlichen in einer Ebene erstreckt, und die Poren (8) auf geeignete Weise ausgeführt werden, damit sie im Wesentlichen parallel zur Ebene der Membran (3) ausgerichtet sind.

5. Verfahren nach einem der vorhergehendenden Ansprüche, in dem die monokristalline Zone der Wand der Poren (8) der nanoporösen Membran (3) dem Boden der Poren (8) entspricht.

6. Verfahren nach einem der Ansprüche 1 bis 5, in dem die nanoporöse Membran (3) in einer dünnen Schicht ausgeführt wird, die auf ein monokristallines Substrat (5) übertragen oder aufgetragen wird.

7. Verfahren nach Anspruch 6, in dem auf dem monokristallinen Substrat (5) eine Sperrschicht (10) realisiert wird, und dies vor der Übertragung oder der Auftragung der dünnen Schicht auf dieses monokristalline Substrat (5), wobei das Material dieser Sperrschicht (10) eine Diffusionssperre bildet und dafür eingerichtet ist, wenigstens teilweise die Verunreinigung des Katalysators (7) durch das Material, aus dem das Substrat (5) besteht, zu verhindern.

8. Verfahren nach einem der vorhergehendenden Ansprüche, in dem vor dem Wachsen des Katalysators (7) in wenigstens einem Teil der Poren (8) der Membran (3) ein Material aufgetragen wird, das eine Diffusionssperre bildet und das dafür geeignet ist, wenigstens teilweise die Verunreinigung des Katalysators (7) durch das Material, das unter ihm liegt, zu verhindern.

9. Verfahren nach einem der vorhergehendenden Ansprüche, in dem in wenigstens einem Teil der Poren (8) der Katalysator (7) durch Elektrodeposition aufgetragen wird.

10. Verfahren nach einem der vorhergehendenden Ansprüche, in dem in wenigstens einem Teil der Poren (8) der Katalysator (7) durch chemische Gasphasenabscheidung aufgetragen wird.

11. Verfahren nach einem der vorhergehendenden Ansprüche, in dem die Auftragung des Katalysators (7) in wenigstens einem Teil der Poren (8) der nanoporösen Membran (3) ausgeführt wird, und der so aufgetragene Katalysator (7) danach getempert wird.

12. Verfahren nach Anspruch 11, in dem das Tempern in einem Magnetfeld ausgeführt wird.

13. Verfahren nach einem der vorhergehendenden Ansprüche, in dem auf der nanoporösen Membran eine elektronische Komponente (50) ausgeführt wird.

14. Verfahren nach einem der vorhergehendenden Ansprüche, in dem die nanoskaligen faserigen Strukturen (63) Nanoröhren aus Kohlenstoff sind.

15. Verfahren nach Anspruch 14, in dem der Katalysator (7) ein Übergangsmetall umfasst.

16. Verfahren nach einem der vorhergehendenden Ansprüche, in dem die Auftragung der faserigen Strukturen (63) durch chemische Gasphasenabscheidung ausgeführt wird.

17. Verfahren nach einem der vorhergehendenden Ansprüche, in dem die nanoskaligen faserigen Strukturen (63) Nanodrähte oder Nanostäbe sind.

18. Verfahren nach Anspruch 17, in dem der Katalysator (7) ein Metall der Liste ist, die Gold und Aluminium umfasst.

19. Komponente für die Elektronik, die wenigstens eine nanoskalige faserige Struktur (63) umfasst, die durch das Verfahren nach einem der vorhergehenden Ansprüche erhalten wurden, wobei diese Komponente (50) folgendes umfasst:
- eine nanoporöse Membran, deren Poren (8) eine monokristalline Zone umfassen,
- einen metallischen Katalysator (7), der in wenigstens einem Teil der Poren (8) der nanoporösen Membran (3) aufgetragen wird, wobei er wenigstens teilweise auf die monokristalline Zone der nanoporösen Membran (3) und auf das mehreren Poren (8) gemeinsame monokristalline Substrat (5) epitaxiert wird.

20. Komponente nach Anspruch 19, bei der wenigstens ein Teil der nanoporösen Membran (3) eine Elektrode (59) bildet, die es gestattet, eine Spannung an wenigstens eine faserige Struktur (63) zu legen, die in einem anderen Teil der nanoporösen Membran (3) aufgetragen ist.

21. Komponente nach einem der Ansprüche 19 und 20, die auf einem Substrat (5) sitzt und die wenigstens eine faserige nanoskalige Struktur (63) umfasst, die sich parallel zur Ebene des Substrats (5) erstreckt.

22. Komponente nach einem der Ansprüche 19 bis 21, die eine Elektrode (85) umfasst, die ihrerseits eine Verlängerung in eine Pore (8) der nanoporösen Membran (3) umfasst.

23. Komponente nach einem der Ansprüche 19 bis 22, bei der wenigstens eine faserige nanoskalige Struktur (63) eine Kohlenstoffnanoröhre ist.

24. Komponente nach einem der Ansprüche 19 bis 22, bei der wenigstens eine faserige nanoskalige Struktur (63) ein Stab oder ein Draht ist.
